# EUROPEAN PATENT SPECIFICATION

(11) **EP 3 906 581 B1**
(45) Date of publication and mention of the grant of the patent: **11.09.2024**
(21) Application number: 19907788.4
(22) Date of filing: 17.12.2019
(51) Int. Cl.: H01L 27/15, H01L 25/16, H01L 33/00, H01L 25/075, H01L 33/50, H01L 33/60, H01L 33/62

(54) **METHOD OF FABRICATING DISPLAY STRUCTURES**
VERFAHREN ZUR HERSTELLUNG VON ANZEIGESTRUKTUREN
PROCÉDÉ DE FABRICATION DE STRUCTURES D'AFFICHAGE

(30) Priority: 02.01.2019 US 201962787505 P
(43) Date of publication of application: 10.11.2021
(73) Proprietor: Lumiode, Inc., Bronx, NY 10451 (US)
(72) Inventor: KYMISSIS, Ioannis, Bronx, New York 10451 (US); HSU, Yu-Jen, Bronx, New York 10451 (US); LEE, Vincent, Bronx, New York 10451 (US); TULL, Brian, Bronx, New York 10451 (US); LEBLEBICI, Sibel, Bronx, New York 10451 (US)
(74) Representative: Meissner Bolte Düsseldorf Patentanwälte Rechtsanwälte Partnerschaft mbB
(86) International application number: PCT/US2019/066940
(87) International publication number: WO 2020/142208

(56) References cited:
- JP-B2- 4 904 150
- US-A1- 2006 071 225
- US-A1- 2014 103 391
- US-A1- 2014 145 204
- US-A1- 2015 279 902
- US-A1- 2017 179 192
- US-A1- 2017 294 479
- US-A1- 2018 122 786
- US-A1- 2018 166 429
- US-A1- 2018 247 922
- US-A1- 2018 269 191
- US-A1- 2018 331 085

## Description

### FIELD OF THE DISCLOSURE

Aspects of the disclosed subject matter relate generally to bonding light emitting diode (LED) display structures, and more particularly to a method of fabricating display structures using LED elements that enable or facilitate improvement of light extraction efficiency, modification of a color of light emitted, and angular output of light from LED structures.

### BACKGROUND

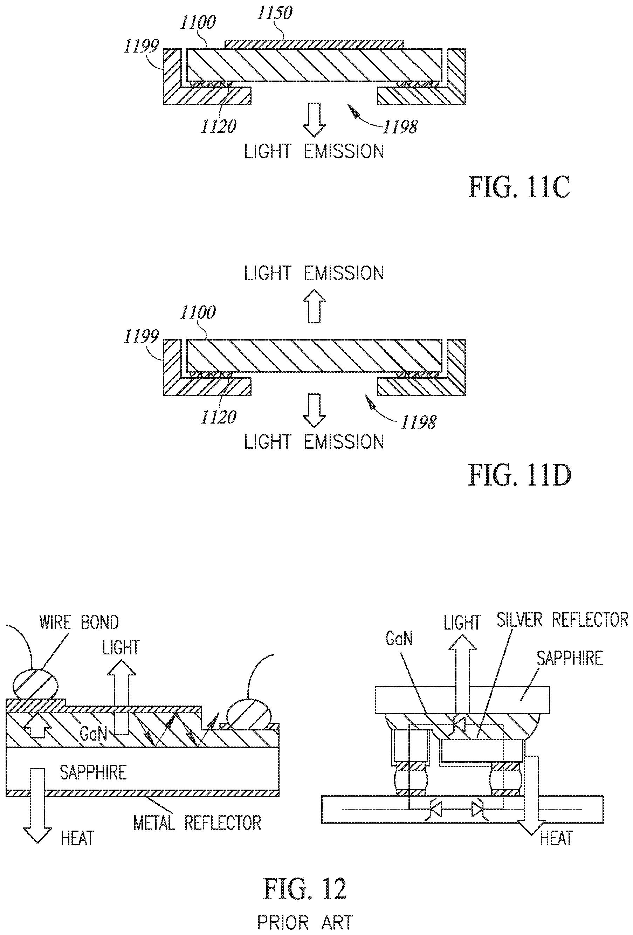

Many investigators working with display instrumentalities have invested significant effort in the development of micro-LED technology with the intention of building high luminance pixelated structures for display and non-display light engine applications. Several technical challenges remain, however, which still need to be overcome to make this technology practical for most commercial applications. Specifically, several groups working in the micro-LED space have proposed a range of architectures for packaging, light extraction, interconnection, and color conversion. For example, a document authored by Shih, et al. ("LED Die Bonding." Materials for Advanced Packaging, Ch. 17, Springer International Publishing, Switzerland, 2017) describes many conventional packaging techniques used for discrete LEDs, which have many similarities and a few differences from the requirements for micro-LEDs. One of the drawing figures from Shih, reproduced as FIG. 12 herein, demonstrates one of the most significant differences between the packaging of discrete LEDs, on the one hand, and micro-LEDs, on the other hand. In traditional LED structures, all light is extracted from the structure with no regard to preserving the relative position of the source. In the case of micro-LEDs, however, light cannot be waveguided across the wafer (which would scramble the source of the light in the structure), which eliminates or diminishes some of the advantages of utilizing micro-LED structures in the first place.

FIG. 12 illustrates two side cross-sectional views of two variants of conventional LED bonding technology. In the implementation illustrated on the left side of FIG. 12, light is extracted from the semiconductor side of the wafer; in the implementation illustrated on the right side of FIG. 12, however, light is extracted through the sapphire layer. In both of these conventional technologies, electrical contacts are made on the semiconductor side, leaving the insulating sapphire layer in place.

In some devices, e.g., such as those described by the Sakakibara et al. document ("Independent drive of integrated multicolor (RGBY) micro-LED array using regularly arrayed InGaN based nanocolumns." 22nd Microoptics Conference (MOC2017), Tokyo, Japan, November 19-22, 2017) an architecture employs LEDs that are patterned into mesas, and both the (negative and positive) n- and p- sides are contacted from the top side. Light in this architecture is extracted from the top side, but may also be extracted from the growth substrate (sapphire) side if the structure is inverted. This connection approach has the advantage of simplicity, but it also has a relatively poor fill factor due to both layers of interconnect sharing area with the patterned LEDs.

The Yeo et al. document ("Micro-LED arrays for display and communication: device structure and driver architecture." 2017 IEEE 12th International Conference on ASIC (ASICON), Guiyang, China, October 25-28, 2017 ) shows a similar architecture, with the same benefits and limitations as the system presented in Sakakibara. Mao describes a system in which a phosphor film is attached to an LED structure using a polysilazine binding layer. These color conversion materials can be used to shift the wavelength of light emitted by an LED to longer wavelengths than might otherwise naturally be emitted from the LED, and if patterned, can allow for multiple wavelengths of light from a single LED structure. Finally, the Maaskant document (U.S. Patent No. 9,515,238) describes a system in which LED chiplets may be placed within a shaped reflector structure. This structure can modify many of the properties of light, including the wavelength (*e.g.,* through the use of phosphors), emission angle (*e.g.,* via lensing), and emission angle and overall light extraction efficiency through the use of scattering layers.

Document US 2018/247922 A1 discloses a method of fabricating display structures comprising the steps of receiving a wafer which comprises a growth substrate and an epitaxial semiconductor layer grown on a first face of the growth substrate, patterning the epitaxial semiconductor layer of the wafer from a front face of the epitaxial semiconductor layer to form a common contact, bonding the common contact to a carrier substrate, and releasing the growth substrate from the epitaxial semiconductor layer to expose a back face of the epitaxial semiconductor layer, the back face opposed from the front face across a thickness of the epitaxial semiconductor layer.

Document US 2006/071225 A1 discloses a similar method of fabricating display structures, and teaches depositing a common contact in form of a top metal electrode layer onto an insulating layer, such that the metal layer will make contacts to the surface of a multi-layer semiconductor structure through respective holes. The final LED structure is comprised of the multi-layer semiconductor structure bonded to a sub-mount and having both bottom and top electrical connections.

Document US 2018/122786 A1 discloses another method of fabricating display structures, in which distinct, and separately addressable, electrodes are used.

Document US 2018/166429 A1 discloses another method of fabricating display structures, in which GaN micro-LEDs having distinct and separately addressable electrodes are employed, such that each pixel of the display structure comprises a pixel driver and a micro LED. Each pixel driver includes a control transistor and a driving transistor.

Though researchers are making advancements in LED display techniques, many of the issues associated with heat sinking, forming electrical contacts, and placement of phosphors for color conversion present universal and recurring challenges for those of skill in the art.

Therefore, there is a need for an improved method of fabricating display structures using LED elements that enable or facilitate improvement of light extraction efficiency, modification of a color of light emitted, and angular output of light from LED structures.

### SUMMARY OF THE DISCLOSURE

The following presents a simplified summary of the disclosure in order to provide a basic understanding of some aspects of various embodiments disclosed herein. This summary is not an extensive overview of the disclosure. It is intended neither to identify key or critical elements of the disclosed embodiments nor to delineate the scope of those embodiments. Its sole purpose is to present some concepts of the subject matter in a simplified form as a prelude to the more detailed description that is presented later.

The invention is defined in claim 1. Advantageous embodiments are defined in the dependent claims.

The present disclosure describes a system and method of structuring light emission engines using LED elements that enable or facilitate improvement of light extraction efficiency, modification of a color of light emitted, and angular output of light from LED structures.

In accordance with one aspect of the disclosed subject matter, a method of fabricating display structures is disclosed comprising: receiving a wafer which comprises a growth substrate and an epitaxial semiconductor layer grown on a first face of the growth substrate; patterning the epitaxial semiconductor layer of the wafer from a front face of the epitaxial semiconductor layer to form a common contact; bonding the common contact to a carrier substrate; releasing the growth substrate from the epitaxial semiconductor layer to expose a back face of the epitaxial semiconductor layer, the back face opposed from the front face across a thickness of the epitaxial semiconductor layer; providing individually addressable contacts on the back face of the epitaxial semiconductor layer, such that the common contact, the epitaxial semiconductor layer, and the individually addressable contacts form a set of micro-light emitting diodes (micro-LEDs); and electrically coupling a set of drive circuitry to the individually addressable contacts to control the micro-LEDs.

A method may further comprise patterning the epitaxial semiconductor layer to form a respective discrete semiconductor element for each of the micro-LEDs. A method is disclosed wherein bonding the common contact to a carrier substrate includes bonding the common contact to a transparent or translucent carrier substrate, where light emission from the micro-LEDs will pass through the transparent or translucent carrier substrate. A method is disclosed further comprising growing the epitaxial semiconductor layer on the first face of the growth substrate. A method is disclosed wherein electrically coupling a set of drive circuitry to the individually addressable contacts to control the micro-LEDs includes electrically coupling a set of complementary metal oxide semiconductor (CMOS) circuits to the individually addressable contacts to control the micro-LEDs.

A method may further comprise: depositing an insulating layer over individually addressable contacts; and forming vias in the insulating layer to provide a set of electrical connections to the individually addressable contacts through the insulating layer.

A method is disclosed wherein electrically coupling a set of drive circuitry to the individually addressable contacts to control the micro-LEDs includes electrically coupling a set of thin film transistor (TFT) circuits to the individually addressable contacts to control the micro-LEDs. A method is disclosed wherein bonding the common contact to a carrier substrate includes bonding the common contact to a translucent carrier substrate that is wavelength selective. A method is disclosed wherein releasing the growth substrate includes performing a laser lift-off. A method is disclosed wherein releasing the growth substrate includes polishing the growth substrate. A method may further comprise removing residue from the polishing of the growth substrate. A method may further comprise adding one or more optical features to the carrier substrate.

In accordance with another aspect of the disclosed subject matter, a method of fabricating display structures is disclosed comprising: receiving a wafer which comprises a growth substrate and an epitaxial semiconductor layer grown on a first face of the growth substrate; patterning the epitaxial semiconductor layer of the wafer from a front face of the epitaxial semiconductor layer to form first conductive contacts at a relatively fine pitch; depositing an insulating layer over the first conductive contacts; forming vias in the insulating layer to provide a set of electrical connections to the first conductive contacts through the insulating layer; depositing second conductive contacts at a relatively coarse pitch that is relatively more coarse than the fine pitch over the insulating layer; selectively electrically connecting ones of the first conductive contacts, through the vias, to ones of the second conductive contacts using the set of electrical connections, such that the first conductive contacts, the epitaxial semiconductor layer, and the second conductive contacts form a set of micro-light emitting diodes (micro-LEDs); electrically coupling the second conductive contacts to a set of drive circuitry to control the micro-LEDs; and bonding the set of drive circuitry to a carrier substrate. A method may further comprise growing the epitaxial semiconductor layer on the first face of the growth substrate.

A method may further comprise adding one or more optical features to the carrier substrate. A method may further comprise releasing the growth substrate from the epitaxial semiconductor layer to expose a back face of the epitaxial semiconductor layer, the back face opposed from the front face across a thickness of the epitaxial semiconductor layer.

A method is disclosed wherein electrically coupling the second conductive contacts to a set of drive circuitry to control the micro-LEDs includes electrically coupling a set of thin film transistor (TFT) circuits or a set of complementary metal oxide semiconductor (CMOS) circuits to the second conductive contacts to control the micro-LEDs. A method is disclosed wherein bonding the set of drive circuitry to a carrier substrate comprises utilizing a material allowing emission of light through the carrier substrate. A method is disclosed wherein allowing emission of light through the carrier substrate comprises transmitting light at a selected wavelength generated by the micro-LEDs through the carrier substrate. A method is disclosed wherein releasing the growth substrate includes performing a laser lift-off. A method is disclosed wherein releasing the growth substrate includes polishing the growth substrate. A method is disclosed wherein releasing the growth substrate includes etching the growth substrate, possibly after other release steps have been performed.

A method is disclosed wherein receiving a wafer which comprises a growth substrate and an epitaxial semiconductor layer grown on a first face of the growth substrate includes receiving a wafer in which the growth substrate is sapphire. Similarly, a method is disclosed wherein receiving a wafer which comprises a growth substrate and an epitaxial semiconductor layer grown on a first face of the growth substrate includes receiving a wafer in which the growth substrate is selected from the group consisting of GaN, InP, InGaAs, Si, SiC, and Ge.

A method is disclosed wherein receiving a wafer which comprises a growth substrate and an epitaxial semiconductor layer grown on a first face of the growth substrate includes receiving a wafer in which the epitaxial semiconductor layer is Gallium Nitride.

A method is disclosed wherein receiving a wafer which comprises a growth substrate and an epitaxial semiconductor layer grown on a first face of the growth substrate includes receiving a wafer in which the epitaxial semiconductor layer comprises Silicon. Similarly, a method is disclosed wherein receiving a wafer which comprises a growth substrate and an epitaxial semiconductor layer grown on a first face of the growth substrate includes receiving a wafer in which epitaxial semiconductor layer comprises a material selected from the group consisting of GaN, InP, InGaAs, Si, SiC, and Ge.

In accordance with another aspect of the disclosed subject matter, a method of fabricating display structures is disclosed comprising: receiving a wafer which comprises a growth substrate and an epitaxial semiconductor layer grown on a first face of the growth substrate; patterning the epitaxial semiconductor layer of the wafer from a front face of the epitaxial semiconductor layer to form first conductive contacts at a relatively fine pitch that is finer than a relatively coarse pitch; depositing an interposer layer on the front face of the epitaxial semiconductor layer over the first conductive contacts; providing drive circuitry which is electrically coupled to the interposer layer, opposed from the epitaxial semiconductor layer, with a set of second conductive contacts, the second conductive contacts disposed at the relatively coarse pitch that is coarser than the fine pitch; and selectively electrically connecting ones of the first conductive contacts, through the interposer layer, to ones of the second conductive contacts, such that the first conductive contacts, the epitaxial semiconductor layer, and the second conductive contacts form a set of micro-light emitting diodes (micro-LEDs) controlled by the drive circuitry. A method may further comprise growing the epitaxial semiconductor layer on the first face of the growth substrate.

A method is disclosed wherein providing drive circuitry comprises electrically coupling a set of thin film transistor (TFT) circuits or a set of complementary metal oxide semiconductor (CMOS) circuits to the interposer layer using the second conductive contacts. A method is disclosed wherein receiving a wafer which comprises a growth substrate and an epitaxial semiconductor layer grown on a first face of the growth substrate includes receiving a wafer in which the growth substrate is sapphire. A method is disclosed wherein receiving a wafer which comprises a growth substrate and an epitaxial semiconductor layer grown on a first face of the growth substrate includes receiving a wafer in which the epitaxial semiconductor layer is Gallium Nitride. A method is disclosed wherein receiving a wafer which comprises a growth substrate and an epitaxial semiconductor layer grown on a first face of the growth substrate includes receiving a wafer in which the epitaxial semiconductor layer comprises Silicon.

In accordance with another aspect of the disclosed subject matter, a method of fabricating display structures is disclosed comprising: receiving a wafer which comprises a growth substrate and an epitaxial semiconductor layer grown on a first face of the growth substrate; patterning the epitaxial semiconductor layer of the wafer from a front face of the epitaxial semiconductor layer to form an interconnect layer comprising drive circuitry; bonding the interconnect layer to a carrier substrate; releasing the growth substrate from the epitaxial semiconductor layer to expose a back face of the epitaxial semiconductor layer, the back face opposed from the front face across a thickness of the epitaxial semiconductor layer; and depositing a color conversion layer on the back face of the epitaxial semiconductor layer, such that the interconnect layer, the epitaxial semiconductor layer, and the color conversion layer form a set of micro-light emitting diodes (micro-LEDs) controlled by the drive circuitry. A method may further comprise growing the epitaxial semiconductor layer on the first face of the growth substrate. A method may further comprise adding a color filter layer to the back face of the epitaxial semiconductor layer, the color filter layer disposed over the color conversion layer.

A method is disclosed wherein releasing the growth substrate includes performing a laser lift-off. A method is disclosed wherein releasing the growth substrate includes polishing the growth substrate. A method is disclosed wherein releasing the growth substrate includes etching the growth substrate. A method is disclosed wherein releasing the growth substrate includes etching the growth substrate following other release process operations.

A method is disclosed wherein depositing a color conversion layer comprises depositing a layer of material that includes a phosphor. A method is disclosed wherein depositing a color conversion layer comprises depositing a layer of material that includes a nanophosphor. A method is disclosed wherein depositing a color conversion layer comprises depositing a layer of material that includes a quantum dot. A method is disclosed wherein depositing a color conversion layer comprises adding an epitaxial semiconductor layer. A method is disclosed wherein adding a color filter layer comprises adding a dielectric filter. A method is disclosed wherein adding a color filter layer comprises adding a dielectric or metallic mirror. A method is disclosed wherein adding a color filter layer comprises adding a plasmonic optical element. A method is disclosed wherein adding a color conversion layer comprises adding a photoluminescent semiconductor structure in which a light emitting bandgap is formed at the desired energy. A method is disclosed wherein adding a color conversion layer comprises adding a wide bandgap semiconductor doped with activators.

A method is disclosed wherein receiving a wafer which comprises a growth substrate and an epitaxial semiconductor layer grown on a first face of the growth substrate includes receiving a wafer in which the growth substrate is sapphire. A method is disclosed wherein receiving a wafer which comprises a growth substrate and an epitaxial semiconductor layer grown on a first face of the growth substrate includes receiving a wafer in which the epitaxial semiconductor layer is Gallium Nitride, Silicon, or Silicon Carbide. A method is disclosed wherein receiving a wafer which comprises a growth substrate and an epitaxial semiconductor layer grown on a first face of the growth substrate includes receiving a wafer in which the epitaxial semiconductor layer comprises Silicon. A method is disclosed wherein receiving a wafer which comprises a growth substrate and an epitaxial semiconductor layer grown on a first face of the growth substrate includes receiving a wafer in which the epitaxial semiconductor layer comprises a material selected from the group consisting of GaN, InP, InGaAs, Si, SiC, and Ge.

A method is disclosed wherein depositing a color conversion layer and adding a color filter layer comprise fabricating the color conversion layer and the color filter layer independently of the epitaxial semiconductor layer to create a color conversion module. A method may further comprise: bonding the color conversion module to the back face of the epitaxial semiconductor layer. A method is disclosed wherein bonding the color conversion module to the back face of the epitaxial semiconductor layer comprises using metal bonding. A method is disclosed wherein bonding the color conversion module to the back face of the epitaxial semiconductor layer comprises using plasma fusion bonding. A method is disclosed wherein bonding the color conversion module to the back face of the epitaxial semiconductor layer comprises use of an adhesive. A method is disclosed wherein bonding the color conversion module to the back face of the epitaxial semiconductor layer comprises using anodic bonding.

In accordance with yet another aspect of the disclosed subject matter, a method of fabricating display structures is disclosed comprising: receiving a wafer which comprises a growth substrate and an epitaxial semiconductor layer grown on a first face of the growth substrate; patterning the epitaxial semiconductor layer of the wafer from a front face of the epitaxial semiconductor layer to form an interconnect layer comprising drive circuitry; bonding the interconnect layer to a carrier substrate; releasing the growth substrate from the epitaxial semiconductor layer to expose a back face of the epitaxial semiconductor layer, the back face opposed from the front face across a thickness of the epitaxial semiconductor layer; and patterning one or more optical extraction elements on the back face of the epitaxial semiconductor layer, such that the interconnect layer, the epitaxial semiconductor layer, and the one or more optical extraction elements form a set of micro-light emitting diodes (micro-LEDs) controlled by the drive circuitry. A method may further comprise growing the epitaxial semiconductor layer on the first face of the growth substrate.

A method may further comprise depositing an electrode on each of the one or more optical extraction elements. A method is disclosed wherein patterning one or more optical extraction elements comprises creating a prism. A method is disclosed wherein patterning one or more optical extraction elements comprises creating an optical grating. A method is disclosed wherein patterning one or more optical extraction elements comprises creating a photonic crystal. A method is disclosed wherein patterning one or more optical extraction elements comprises creating a lens. A method is disclosed wherein patterning one or more optical extraction elements comprises creating a shallow etched Fresnel lens.

A method is disclosed wherein receiving a wafer which comprises a growth substrate and an epitaxial semiconductor layer grown on a first face of the growth substrate includes receiving a wafer in which the growth substrate is sapphire. A method is disclosed wherein receiving a wafer which comprises a growth substrate and an epitaxial semiconductor layer grown on a first face of the growth substrate includes receiving a wafer in which the epitaxial semiconductor layer is Gallium Nitride, Gallium Arsenide, Indium Phosphide, or comprises Silicon.

A method is disclosed wherein growing the epitaxial semiconductor layer comprises allowing the semiconductor layer to grow to a thickness sufficient to accommodate a depth of the one or more optical extraction elements.

In accordance with another aspect of the disclosed subject matter, a method of fabricating display structures is disclosed comprising: receiving a wafer which comprises a growth substrate and an epitaxial semiconductor layer grown on a first face of the growth substrate; patterning the epitaxial semiconductor layer of the wafer from a front face of the epitaxial semiconductor layer to form an interconnect layer comprising drive circuitry; bonding the interconnect layer to a carrier substrate; polishing the growth substrate to create a residual growth substrate layer on a back face of the epitaxial semiconductor layer, the back face opposed from the front face across a thickness of the epitaxial semiconductor layer; and patterning one or more optical extraction elements on the residual growth substrate layer, such that the interconnect layer, the epitaxial semiconductor layer, and the one or more optical extraction elements form a set of micro-light emitting diodes (micro-LEDs) controlled by the drive circuitry. A method may further comprise growing the epitaxial semiconductor layer on the first face of the growth substrate.

A method may further comprise depositing an electrode on each of the one or more optical extraction elements. A method may further comprise depositing a mirror on each of the one or more optical extraction elements. A method is disclosed wherein patterning one or more optical extraction elements comprises creating a prism. A method is disclosed wherein patterning one or more optical extraction elements comprises creating an optical grating. A method is disclosed wherein patterning one or more optical extraction elements comprises creating a photonic crystal. A method is disclosed wherein patterning one or more optical extraction elements comprises creating a lens. A method is disclosed wherein patterning one or more optical extraction elements comprises creating a shallow etched Fresnel lens. A method is disclosed wherein patterning one or more optical extraction elements comprises creating a series of scattering elements.

A method is disclosed wherein receiving a wafer which comprises a growth substrate and an epitaxial semiconductor layer grown on a first face of the growth substrate includes receiving a wafer in which the growth substrate is sapphire. A method is disclosed wherein receiving a wafer which comprises a growth substrate and an epitaxial semiconductor layer grown on a first face of the growth substrate includes receiving a wafer in which the epitaxial semiconductor layer is Gallium Nitride, Gallium Arsenide, Indium Phosphide, or comprises Silicon. A method is disclosed wherein polishing the growth substrate comprises allowing the residual growth substrate layer to remain at a thickness sufficient to accommodate a depth of the one or more optical extraction elements.

In accordance with yet another aspect, a display structure is disclosed comprising: a semiconductor device layer having a front face and a back face, the back face opposed from the front face across a thickness of the semiconductor device layer, and comprising a set of micro-light emitting diodes (micro-LEDs); a carrier supporting the semiconductor device layer on the back face, the carrier having, for each respective micro-LED in the set of micro-LEDs, a respective aperture allowing light emitted by the respective micro-LED to exit the carrier; and a bond electrically coupling each respective micro-LED in the set of micro-LEDs to the carrier.

A display structure is disclosed wherein light emitted from a respective one of the micro-LEDs in the set of micro-LEDs is allowed to exit the carrier from the back face of the semiconductor device layer through the respective aperture and from the front face of the semiconductor device layer opposite the respective aperture.

A display structure may further comprise: for respective ones of the set of micro-LEDs, a respective reflective electrode to control a direction of light emitted from a respective micro-LED in the set of micro-LEDs. A display structure is disclosed wherein the respective reflective electrode is disposed on the back face of the semiconductor device layer proximal to the respective aperture to prevent light from exiting the respective aperture. A display structure is disclosed wherein the respective reflective electrode is disposed on the front face of the semiconductor device layer opposite the respective aperture to direct light through the respective aperture. A display structure is disclosed wherein the semiconductor device layer comprises Gallium Nitride or Silicon. A display structure is disclosed wherein the bond is a wire bond. A display structure is disclosed wherein the bond is a solder bump.

The foregoing and other aspects of various disclosed embodiments will be apparent through examination of the following detailed description thereof in conjunction with the accompanying drawing figures, in which like reference numerals are used to represent like components throughout, unless otherwise noted.

### DESCRIPTION OF THE DRAWING FIGURES

FIG. 1 illustrates a series of side cross-sectional views depicting aspects of one process according to the invention in accordance with which a micro-LED may be processed with a common electrode and may be bonded to a carrier substrate;
FIG. 2 illustrates a series of side cross-sectional views depicting aspects of one process according to the invention in accordance with which a micro-LED may be released from a growth substrate and bonded individually from a backside layer after removal of the growth substrate;
FIG. 3A illustrates a series of side cross-sectional views depicting aspects of one process not falling within the scope of the invention using an interconnect layer on a substrate to expand a connection pitch of external contacts to a micro-LED structure;
FIG. 3B illustrates two plan views depicting a result of the process illustrated in FIG. 3A;
FIG. 3C illustrates a side cross-sectional view depicting aspects of one implementation not falling within the scope of the invention of drive circuitry to control a micro-LED structure.
FIG. 3D illustrates a side cross-sectional view depicting aspects of another implementation not falling within the scope of the invention of drive circuitry to control a micro-LED structure.
FIG. 3E illustrates a series of side cross-sectional views depicting aspects of one process not falling within the scope of the invention of releasing the implementation of FIG. 3A from a growth substrate
FIG. 4 illustrates a series of side cross-sectional views depicting aspects of one process not falling within the scope of the invention of fabricating a micro-LED structure using an interposer layer
FIG. 5 illustrates a series of side cross-sectional views depicting aspects of one process not falling within the scope of the invention of fabricating a micro-LED architecture including a color conversion layer
FIG. 6 illustrates a series of side cross-sectional views depicting aspects of another process not falling within the scope of the invention of fabricating a micro-LED architecture including an optical filter
FIG. 7 illustrates a series of side cross-sectional views depicting aspects of another process not falling within the scope of the invention of fabricating a micro-LED architecture including a color conversion module;
FIG. 8 illustrates a series of side cross-sectional views depicting aspects of a process not falling within the scope of the invention of fabricating a micro-LED structure in accordance with which, after separation of a growth substrate, light extraction features may be patterned into the semiconductor layer itself;
FIG. 9 illustrates a series of side cross-sectional views depicting aspects of a process not falling within the scope of the invention of fabricating a micro-LED structure in accordance with which some of the growth substrate may be retained, and light extraction features may be patterned into the growth substrate;
FIG. 10 illustrates another series of side cross-sectional views depicting aspects of a process not falling within the scope of the invention of fabricating a micro-LED structure in accordance with which, after separation of a growth substrate, light extraction features may be patterned into the semiconductor layer itself;
FIGS. 11A through 11D are side cross-sectional views of configurations of packaging for a micro-LED device not falling within the scope of the invention, illustrating possibilities for interconnect and light extraction using a carrier; and
FIG. 12 illustrates two side cross-sectional views of two variants of conventional LED bonding technology.

### DETAILED DESCRIPTION

Certain aspects and features of the disclosed subject matter may be further understood with reference to the following description and the appended drawing figures. In operation, a system and method may enable or facilitate integration of LED implementations with display technologies that allows for the co-integration of significant elements of the display structure with interconnect hardware, light management elements, and color conversion components. In that regard, one aspect of the disclosure addresses development of a structure that allows for a higher density of interconnections than is achievable with current or traditional approaches. In accordance with a second aspect, the disclosed subject matter addresses a structure that may allow for lower fabrication costs and higher performance; improvements may be achieved in terms of processing and handling techniques associated with fabrication of optical elements for LED device structures as well as the output performance and power consumption of these elements. Additionally or alternatively, the disclosed subject matter may enable or facilitate a superior fill factor for micro-LED displays, providing or allowing greater utilization of an active area of a device in situations or applications in which optimization of silicon real estate is desired or important.

Some implementations of disclosed optical elements include structures that may convert a color of a display, improve an angular emission profile, reduce crosstalk, and improve efficiency of light extraction from an LED device or structure. An additional benefit of the disclosed implementations may result in flexibility to extract light from either a first side (i.e., the free surface after epitaxial LED growth) or a second side (i.e., the surface attached to the single crystal substrate during epitaxial growth) after fabrication, as well as an option to configure a disclosed device for common electrodes made from the p- or n-type semiconductor material in the LED, which may offer advantages for circuit interconnect applications.

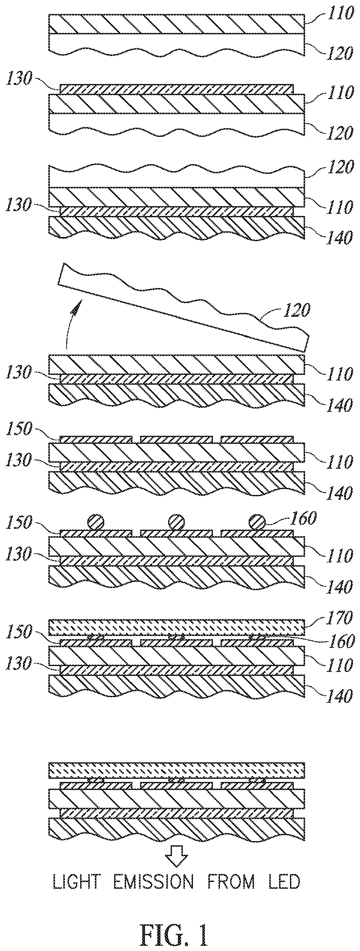

FIG. 1 illustrates a series of side cross-sectional views depicting aspects of one process according to the invention in accordance with which a micro-LED is processed with a common electrode and is bonded to a carrier substrate. As indicated in FIG. 1, such a process begins with an epitaxial LED layer 110 formed on a growth (or "epitaxial") substrate 120; a common contact layer 130 is patterned on LED layer 110. At this point, the structure may be inverted and is bonded to a carrier substrate 140. The present disclosure is not intended to be limited by the materials used for growth substrate 120 or carrier substrate 140, and it is noted that those of skill in the art will appreciate that any of various materials may be suitable, and may be application-specific.

The LED structure is released from growth substrate 120 (for example, via a laser lift-off technique, chemical etching, backgrinding, or other mechanism generally known in the art), and functional LED elements (e.g., contacts, solder balls, drive circuitry, and the like) may then be bonded individually, and sequentially, from the backside layer after removal of growth substrate 120. This implementation allows for the formation of individually addressable micro-LED elements in which singulated access is formed on the backside of the PIN junction layer. In the FIG. 1 diagram, connection is shown via the formation of bump bonds 160 on contacts 150 and hybridization with a CMOS integrated drive circuit 170.

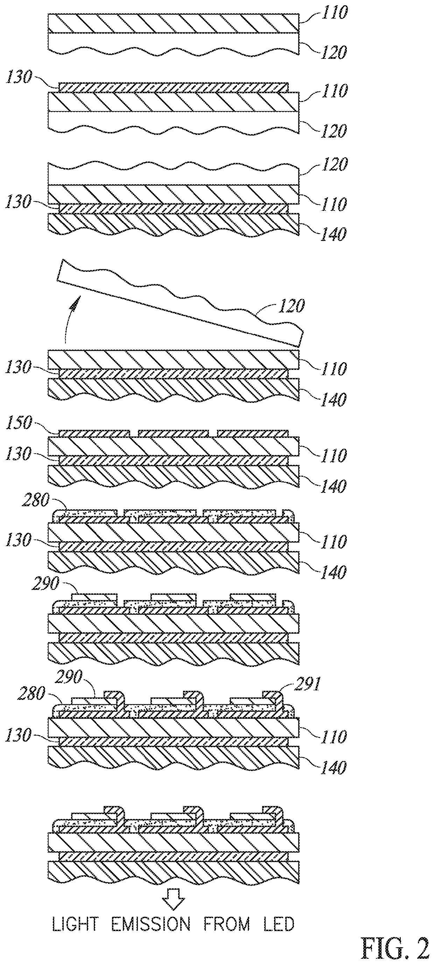

FIG. 2 illustrates a series of side cross-sectional views depicting aspects of one process according to the invention in accordance with which a micro-LED is released from a growth substrate and bonded individually from a backside layer after removal of the growth substrate. The FIG. 2 implementation begins in a manner that is similar to that illustrated in FIG. 1; the processes diverge after the structure has been inverted, growth substrate 120 has been released, and individually addressable contacts 150 have been patterned. In the FIG. 2 implementation, for instance, individual addressing may generally be achieved through the use of a thin film transistor (TFT) control and drive layer 290 which is fabricated on the backside of the structure. Specifically, contacts 150, an insulation layer and vias 280, TFT layers 290, and electrical contacts 291 (traversing the vias) may be formed individually, and sequentially, from the backside layer after removal of growth substrate 120.

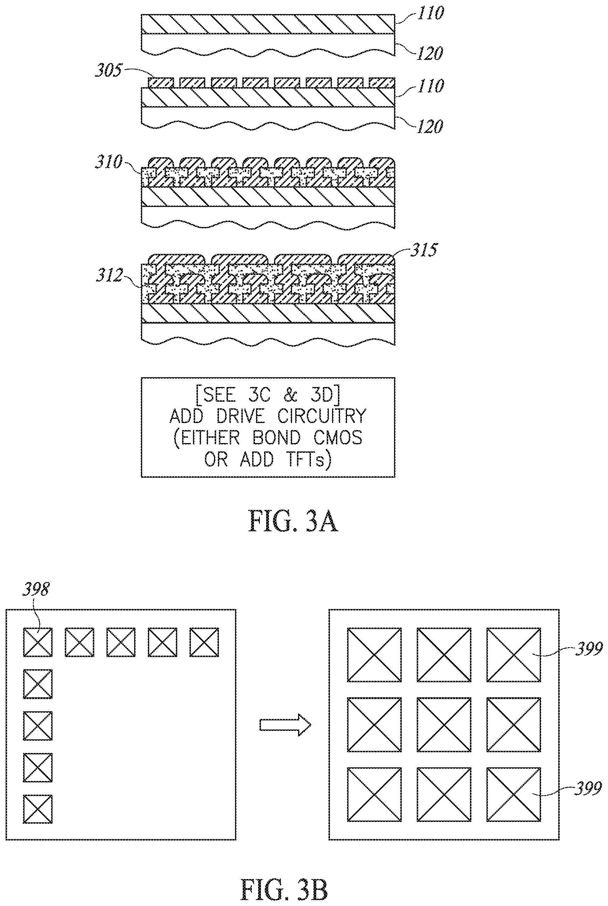

FIG. 3A illustrates a series of side cross-sectional views depicting aspects of one process using an interconnect layer on a substrate to expand a connection pitch of external contacts to a micro-LED structure, and FIG. 3B illustrates two plan views depicting a result of the process illustrated in FIG. 3A. In the implementation of FIGS. 3A and 3B, in which a micro-LED is addressed in a row and column format, for example, the connection pitch is typically required at the row or column pitch, and the central area is left unconnected. In a bottom emission architecture, however, the interconnect layers can be used to allow for the formation of a coarser structure with the same number of contacts but a larger spacing between elements. The top-down plan view (FIG. 3B) schematically shows this architecture. Specifically, FIGS. 3A and 3B illustrate a micro-LED layer 110 grown on a sapphire epitaxial layer 120. It is noted that materials other than sapphire are generally known for this purpose, and may be selected as a matter of design choice as suitable for particular applications. The present disclosure is not intended to be limited by any particular material used as a growth or epitaxial substrate 120, and those of skill in the art will appreciate that such a substrate may be selected as a function of any of a variety of factors, including but not limited to the chemical or crystalline properties of material used for LED layer 120, the type of processing expected or desired, chemicals, reagents, or other ingredients used in subsequent processing procedures, or a combination of these and other factors. A metal layer 305, at a fine pitch, may be deposited on the LED layer 110 using techniques generally known in the art or developed in accordance with known principles. An insulating layer 310, vias, and interconnects (not illustrated for clarity) may then be deposited in a similar manner in accordance with known techniques. Processing may continue with the deposition and patterning of an additional insulation layer 312, together with additional vias and interconnects 315, fabricated at a coarser pitch than the underlying layer. As noted above, the result of this approach is illustrated in plan view at FIG. 3B, and generally may result in larger micro-LEDs (reference numeral 399) as compared with conventional approaches, which result in smaller devices (reference numeral 398).

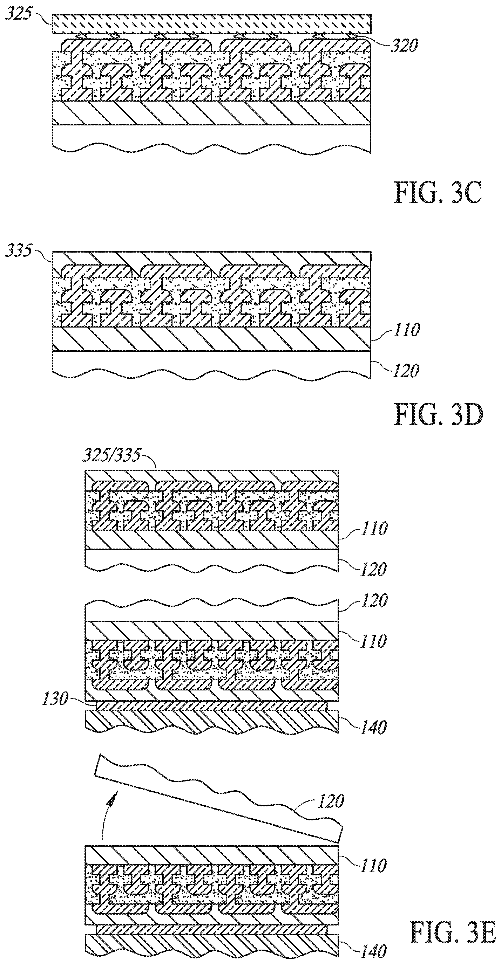

As indicated at the bottom of FIG. 3A, drive and control circuitry may be deposited or processed above the (relatively) coarser pitched structure, either as bonded CMOS structures or added TFT structures. Several options for such processing methodologies are illustrated in FIGS. 3C, 3D, and 3E. In that regard, FIG. 3C illustrates a side cross-sectional view depicting aspects of one implementation of drive circuitry to control a micro-LED structure, FIG. 3D illustrates a side cross-sectional view depicting aspects of another implementation of drive circuitry to control a micro-LED structure, and FIG. 3E illustrates a series of side cross-sectional views depicting aspects of one process of releasing the implementation of FIG. 3A from a growth substrate

For example, FIG. 3C illustrates an implementation in which individually addressable drive control circuitry 320 may be deposited on each respective interconnect 315, and interposed between such interconnect 315 and a CMOS layer 325. As an alternative, FIG. 3D illustrates such drive control circuitry integrated into a TFT layer 335 deposited directly to the top insulation layer 312 and electrically coupled to interconnects 315. In the FIG. 3E implementation, drive and control circuitry 325/335 may be added as set forth above in either of FIGS. 3C or 3D; as indicated in FIG. 3E, however, processing may continue by inverting the structure and bonding drive circuitry 325/335 to a carrier substrate 140, such as via a contact layer 130 described above with reference to FIGS. 1 and 2. Growth substrate 120 may then be released substantially as described above (*e.g.,* such as by chemical or other etching, backgrinding, laser lift-off, or other techniques).

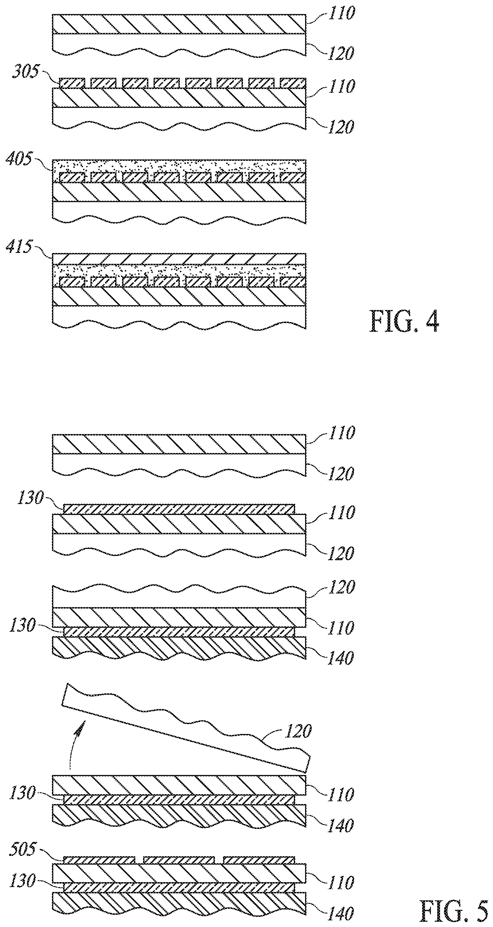

FIG. 4 illustrates a series of side cross-sectional views depicting aspects of one process of fabricating a micro-LED structure using an interposer layer. The FIG. 4 process begins in much the same manner as that described above with reference to FIG. 3. Specifically, FIG. 4 illustrates an LED layer 110 grown on a sapphire epitaxial layer 120. A metal layer 305, at a fine pitch, may be deposited on LED layer 110 using any of a variety of known techniques. An interposer layer 405 may then be bonded to LED layer 110 and metal layer 305 as indicated in FIG. 4; as illustrated, interposer layer 405 may be disposed intermediate metal layer 305 and control circuitry 415. In this context, control circuitry 415 may be implemented as a CMOS layer (such as 325) or as TFTs (such as 335).

FIG. 5 illustrates a series of side cross-sectional views depicting aspects of one process of fabricating a micro-LED architecture including a color conversion layer. As indicated in FIG. 5, a process for creating such an architecture may begin with an epitaxial LED layer 110 formed on a growth substrate 120; a common contact layer 130 (*e.g.,* for control circuitry and interconnects) may be patterned on LED layer 110. At this point, the structure may be inverted and bonded to a suitable carrier substrate 140. The LED structure may then be released from growth substrate 120 (for example, via a laser lift-off technique, chemical etching, backgrinding, or other mechanism generally known in the art). After structuring of the micro-LEDs and release of the growth substrate, a layer of color conversion materials 505 (e.g., quantum dots, additional epitaxial layers, nanophosphors, *etc*.) may be added to LED layer 110 as indicated at the bottom of FIG. 5. In some implementations, color conversion layer 505 may be patterned into a pixel-specific or subpixel color format; alternatively, color conversion layer 505 may be used to convert an entire display (*i.e.,* all the LEDs in a device) to a single color of broad or narrow spectrum. In this latter alternative, it may be possible to create a red display, a white display, or a display of a desired or required color, even in instances where an LED structure would not otherwise emit light of such a color in the absence of color conversion layer 505. Those of skill in the art will appreciate that color conversion layer 505 may be embodied in or comprise phosphors, phosphor solutions, mixtures of phosphors with silicone or other components, additional semiconductor elements such as photoluminescent semiconductors, quantum dots, or activator-based phosphor devices, or other compositions of matter generally known in the art or developed and operative in accordance with known techniques to alter or otherwise to modify wavelengths of light emitted by LED structures.

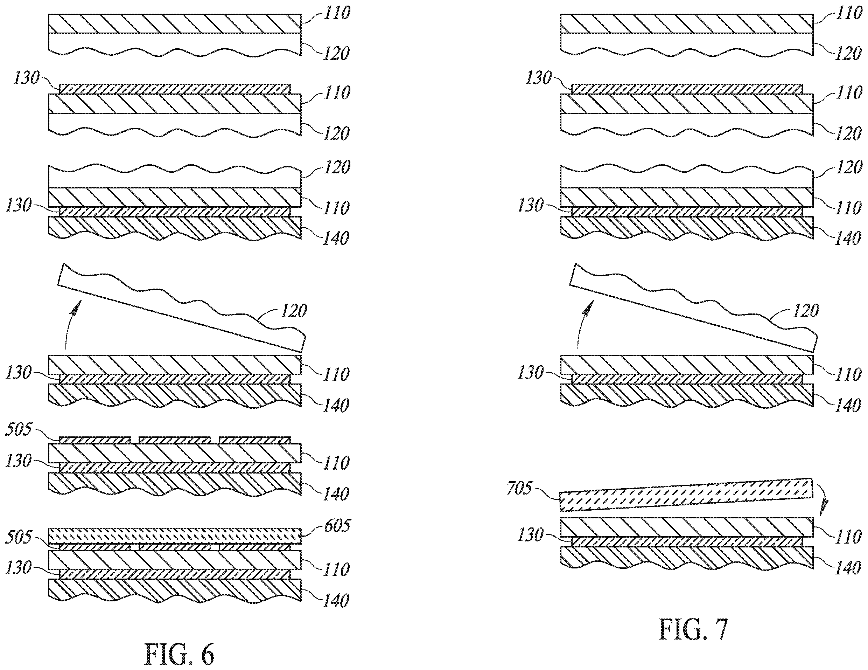

FIG. 6 illustrates a series of side cross-sectional views depicting aspects of another process of fabricating a micro-LED architecture including an optical filter. Specifically, the FIG. 6 implementation is similar to that illustrated in FIG. 5, but includes an optical filter layer 605 disposed above color conversion layer 505. In some implementations, optical filter layer 605 may be used to reduce content of excitation light from the final emitted light; additionally or alternatively, optical filter layer 605 may be spatially structured (*e.g.,* with intermediary gaps or interstitial spaces with no filtering effects) to provide for or otherwise to facilitate a color-selective pixel format. It is noted that color filter layer 605 is not intended to be limited to any particular chemical constituents or structural properties, and that various color filtering methodologies and architectures are generally known for such purposes and may be suitable, depending upon the desired or required operational characteristics of the LEDs, the desired output of emitted light, the nature of the processing operations, cost considerations, or a combination of these and other factors.

FIG. 7 illustrates a series of side cross-sectional views depicting aspects of another process of fabricating a micro-LED architecture including a color conversion module. Creation of the structure illustrated in FIG. 7 may begin substantially as set forth above with reference to FIGS. 5 and 6. As indicated in FIG. 7, however, a color conversion layer (or "plate" or "module") 705 may be fabricated separately and bonded to LED layer 110 as an independent unit or module. This implementation may facilitate efficiencies and enable easy scaling of fabrication, as LED structures, color conversion modules 705, or both may be independently fabricated on an "as needed" or "just in time" (JIT) basis. The present disclosure is not intended to be limited to the type or operational characteristics on the materials or architectures of color conversion module 705, or by the methodologies or processing techniques employed to bond such a color conversion module 705 to the LED structure. In some circumstances, for instance, it may be desirable to integrate color conversion layer 505 and color filter layer 605 into a single color conversion module 705, though other alternatives are possible. Specifically, color conversion module 705 may be embodied in or comprise any of various structures, either individually or in combination, including but not limited to color conversion layer 505, color filter layer 605, and other devices or materials operative to alter or otherwise to influence a wavelength of light emitted from LED or micro-LED architectures.

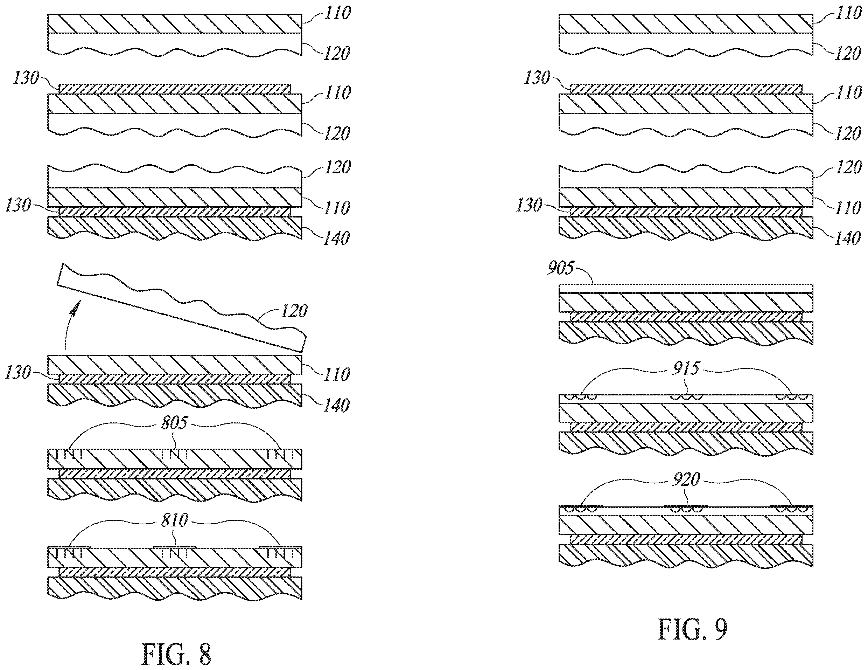

FIG. 8 illustrates a series of side cross-sectional views depicting aspects of a process of fabricating a micro-LED structure in accordance with which, after separation of a growth substrate, light extraction features may be patterned into the semiconductor layer itself. As with the implementation described above with reference to FIG. 7, creation of the structure illustrated in FIG. 8 may begin substantially as set forth above with reference to FIGS. 5 and 6. As indicated in FIG. 8, however, following release of growth substrate 120, LED layer 110 itself may be patterned with optical extraction elements, components, or other structures (reference numeral 805) designed and operative to produce desired or required effects on the light ultimately emitted by components in LED layer 110. It will be appreciated that the patterning illustrated in FIG. 8 may be by chemical or mechanical etching, for instance, or other techniques generally known in the art. It is noted that optical extraction elements 805 may be embodied in or comprise, for example, prisms, photonic crystals, or other structures or optical elements or components that may be patterned, etched, ground, grown, or otherwise formed as desired in LED layer 110 to influence the light emitted by LED layer 110. Electrodes or contacts (reference numeral 810) may be layered upon optical extraction elements 805 as indicated at the bottom of FIG. 8, creating individually addressable LED components substantially as set forth above.

FIG. 9 illustrates a series of side cross-sectional views depicting aspects of a process of fabricating a micro-LED structure in accordance with which some of the growth substrate may be retained, and light extraction features may be patterned into the growth substrate. Creation of the structure illustrated in FIG. 9 may begin substantially as set forth above with reference to FIG. 8. In the FIG. 9 implementation, however, growth substrate 120 may not be released, but rather polished down; the polishing operation may terminate before reaching LED layer 110, leaving a portion of the growth layer 120 remaining (*i.e.,* a residual growth substrate layer 905). Following suitable polishing (which may be in accordance with any of various well-known techniques), the remaining residual growth substrate layer 905 itself may be patterned with optical extraction elements, components, or other structures (reference numeral 915) designed and operative to produce desired or required effects on the light ultimately emitted by components in LED layer 110. The optical extraction elements 915 depicted in FIG. 9 may be similar or analogous to those (reference numeral 805) illustrated in FIG. 8, but the manner in which they are patterned or formed may be influenced or affected by the nature of residual growth substrate layer 905, *e.g.,* as compared to the materials, depth, and physical properties of LED layer 110 in FIG. 8. Those of skill in the art will appreciate that different techniques may be suitable or applicable for patterning optical extraction elements 915 as a function of the material, physical, or chemical properties of residual growth substrate layer 905, its depth, optical characteristics, or a combination of these and other factors. As with the FIG. 8 implementation, electrodes or contacts 920 may be layered upon such optical extraction elements 915 as indicated at the bottom of FIG. 9, creating individually addressable LED components.

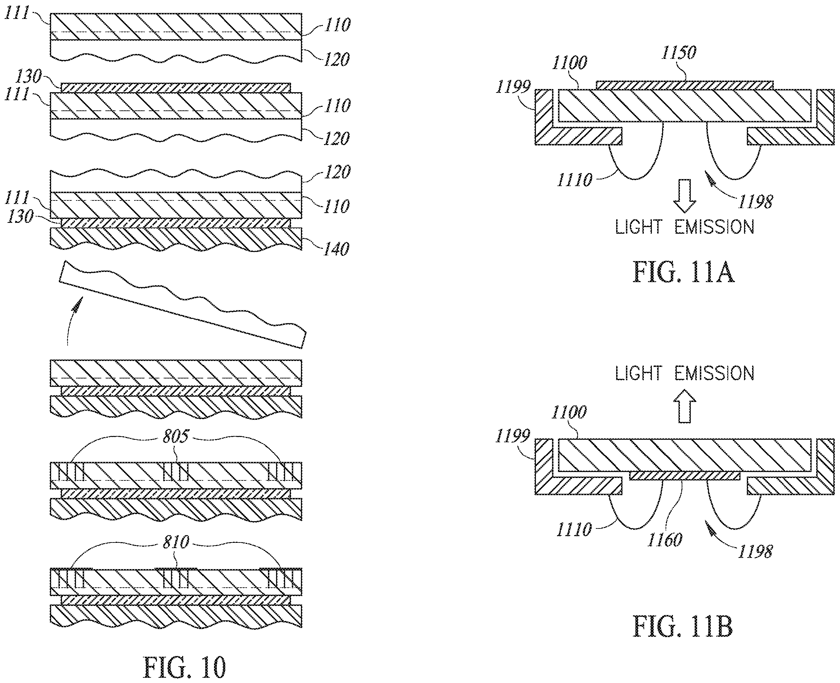

FIG. 10 illustrates another series of side cross-sectional views depicting aspects of a process of fabricating a micro-LED structure in accordance with which, after separation of a growth substrate, light extraction features may be patterned into the semiconductor layer itself. The FIG. 10 implementation is similar to that illustrated in FIG. 8, but the FIG. 10 implementation uses a thicker LED semiconductor layer as indicated by the dashed horizontal line; specifically, additional material 111 is added (or allowed to grow), making semiconductor layer 110 thicker than that illustrated in the FIG. 8 implementation. The thicker semiconductor layer (110 and 111) in FIG. 10 may generally allow for or facilitate creation of features (such as optical extraction elements 805) of higher aspect ratio and relief than may be possible with standard epitaxy growth. It is appreciated that the FIG. 10 implmentation may make it easier or more efficient to build an optical well in a GaN or sapphire substrate (or other semiconductor material generally indicated at 110 and 111) that may be employed to hold or otherwise to accommodate color conversion materials and/or to facilitate or to execute light shaping in a desired or required manner. In that regard, semiconductor layer 110 and extra material 111 may be selected or engineered so as to include or comprise extra GaN (or other semiconductor material) to facilitate construction of optical layers; in some implementations, this extra thickness (as represented by reference numeral 111) may be formed of another material with a different index (*e.g.,* something that suppresses waveguiding or otherwise influences optical characteristics) from material used in the underlying semiconductor layer 110. It is also noted that additional material 111 may not be necessary to achieve these results, and that the FIG.8 implementation may be employed for various applications in which the optical extraction elements 805 are selected to have an appropriate aspect ratio or other structural characteristics.

FIGS. 11A through 11D are side cross-sectional views of configurations of packaging for a micro-LED device, illustrating possibilities for interconnect and light extraction using a carrier. FIGS. 11A through 11D depict a finished wafer 1100 supported by a carrier 1199. Carrier 1199 includes an aperture 1198 allowing light emitted by wafer 1100 to exit carrier 1199 in some implementations. It is noted that, though only a single aperture 1198 is illustrated for clarity, carrier 1199 may include or incorporate a respective aperture 1198 for each respective LED or micro-LED structure in wafer 1100; alternatively, a respective aperture 1198 may be provided for a set or group of LEDs or micro-LEDs disposed in proximity or clustered together on wafer 1100. Those of skill in the art will appreciate that various alternatives exist, and that the illustrations in FIGS. 11A through 11D are provided by way of example only, and not by way of limitation.

Reflective electrodes 1150 and 1160 may be utilized to control a direction of light emitted by wafer 1100 as it exits carrier 1199.

In the FIG. 11A implementation, finished wafer 1100 is wirebonded (reference numeral 1110) to carrier 1199, and light is extracted from the wirebond side of wafer 1100 using reflective electrodes 1150 on the far side of the LED layer. In this configuration, light from wafer 1100 is directed to exit carrier 1199 through aperture 1198. Heatsinking may be incorporated on the reflective electrode 1150 side without interfering with light emission from aperture 1198. Alternatively, in the FIG. 11B configuration, light is extracted from the side opposing the wirebonds 1110, facilitated by reflective electrodes 1160 on the wirebond side; in particular, reflective electrodes 1160 may prevent light from exiting aperture 1198. Heatsinking in this alternative implementation, if incorporated, may be placed on the wirebond side.

FIG. 11C illustrates carrier 1199 electrically coupled to LED or micro-LED elements in wafer 1100 using bump bonds 1120 as electrical connection elements; in this implementation, light extraction may occur from the contacting side (i.e., through aperture 1198), with reflective electrodes 1150 on the opposing side. Alternatively, FIG. 11D illustrates carrier 1199 interfaced with wafer 1100 using bump bonds 1120 (as with FIG. 11 C), with optical transparency on both sides of wafer 1100. As indicated in the drawing figure, this alternative structural arrangement may allow light emission from both sides of wafer 1100.

The foregoing written description and the drawing figures are provided by way of example only, and not by way of limitation. Those of skill in the art will appreciate that the disclosed subject matter is susceptible of various modifications and alternations, which may be application- or materials-specific. Additional background material and use cases are described below, also by way of example and not by way of limitation.

LED epitaxial wafers are typically processed into array micro-LED displays by accessing the n- and p-layers from one side of the structure. Such typical processing allows for retaining the epitaxial wafer (*i.e.,* the LED substrate or layer, such as 110) on the growth substrate (such as 120). Growth substrate 120 in many cases may be or include sapphire, but as noted above, the present disclosure is not intended to be so limited. In that regard, growth substrate 120 set forth herein may be implemented as GaN, SiC, Si, or other suitable crystalline material, and may be selected as a function of processing considerations, cost, operational characteristics, or other factors. Those of skill in the art will appreciate that any such crystalline material capable of maintaining the monolithic integrity of the LED assembly may be used as desired or as a design choice.

Recently, researchers and engineering teams have made significant advances in the processes used to release active semiconductor films from growth substrates; some of these advances include the use of laser lift-off procedures as well as precision grindback, polishing, and etching processes, which allow for the removal of most or all of the growth substrate while keeping the semiconductor layer intact and preserving the favorable qualities of the underlying semiconductor. Such processes open several options for interconnection of the LED structure which can provide advantages including, but not limited to, superior access to semiconductor junction layers for flexible circuit design and integration (*e.g.,* the potential of configuring devices in a common anode or common cathode configuration independent of the growth sequence), superior heat extraction, and a reduced need for opaque metal layers or interconnect structures that can reduce the fill factor of the LED. An additional advantage of this approach is the ability to pattern electrodes on either side, or on both sides, of the LED structure. The ability to tune the polarity of the LEDs may have particular utility for co-integrated circuitry which offers only NMOS or PMOS transistors which will typically have superior current control in only one polarity.

One approach described herein includes the singulation of interconnect from the backside of the LED in structures in which the emission is effectuated from the semiconductor topside. In accordance with one aspect, a structure may be fabricated by first partially processing the LED structures and bonding the LED layer to a carrier (see, *e.g.,* FIGS. 1 and 2). This bonding may be achieved through a number of temporary or permanent bonding technologies or techniques, including metal eutectic bonding, the use of adhesives (including hot melt adhesives, soluble glue, epoxy, or other adhesive suitable for lamination), dielectric bonding, cold plasma bonding, fusion bonding, anodic bonding, or other techniques known in the art or developed and operative in accordance with known principles. Once this bonding has been effectuated, the growth substrate may be removed (either entirely or partially), for example, using a technique such as laser lift-off, precision grinding, selective etching, polishing, or other techniques. The LEDs may then be bonded from the backside at the exposed semiconductor layer of the LED to a hybrid control structure such as a CMOS integrated circuit with top level vias offering control drive circuitry at the array, pixel, or sub-array level. This strategy is illustrated in FIG. 1 and described above with reference thereto.

In some implementations, bonding to a target substrate may be performed before laser lift-off. Such bonding may be permanent (*e.g.,* using metal bonding, cold plasma bonding, *etc*.) or temporary (*e.g.,* using a solid temporary adhesive tape or attachment using a hot melt material such as Crystal Bond or Piccolastic). As is generally known, debonding may occur through or be facilitated by application of ultraviolet or thermal energy, solvents, or other triggered release mechanisms.

In accordance with another implementation, an LED wafer may be partially processed, and then inverted and attached to a carrier substrate (as illustrated in FIG. 1), but the growth substrate may then be removed such that TFT circuitry may be deposited and patterned onto the LED. This strategy is illustrated in FIG. 2 and described above.

In typical or conventional systems or processing methodologies, the growth layer may be removed with laser lift-off techniques, in accordance with which laser output is applied; a laser is selected to output energy that is absorbed by the LED semiconductor layer but is transmitted by the growth substrate. When such laser output is applied to the backside of the substrate, an energetic disruption is created at the interface between the LED semiconductor layer and growth substrate. As an example, a 355 Nd-YaG third harmonic laser can be used to separate a GaN LED and a sapphire (Al2O3) growth substrate, though other laser solutions may be selected as a function of or influenced by the materials used and their physical and energy-transmissive properties, or as a combination of these and other factors. As an alternative to laser lift-off, it is also possible to use precision thinning techniques to polish the growth substrate and/or terminate a polishing or etch process through final etching of the growth substrate layer. As noted above with reference to FIG. 9, it may be desirable in some instances to terminate such polishing or etching before the entire growth substrate layer is removed.

In accordance with another implementation (see, e.g., FIG. 3 for cross-sectional and top views) the peripheral array drive of the LEDs as patterned may be redistributed to a two-dimensional (2D) array of bondpads using, for instance, reconfiguration through two or more layers of inter-level interconnect and vias to reconfigure the structure. This processing allows for the bonding pads to be more uniformly distributed over the LED, allowing for more space between elements and/or larger bondpads than may otherwise be available in a structure directly addressed via rows and columns. The LED may be configured as a passive matrix array, or as an active matrix (e.g., via deposition of a TFT array layer) before the peripheral interconnect structures are reconfigured and attached.

The stack constructed in accordance with the FIG. 3 architecture may be attached to perimeter drive and addressing circuitry using hybrid bonding (FIG. 3C), and may employ deposited TFTs for perimeter control and/or addressing (FIG. 3D). As noted above, subsequent processing as described with reference to other architectures using inversion of the transmission side and/or optimization of the optical extraction may be performed as indicated at FIG. 3E.

In another implementation, a processed micro-LED device may be inverted and bonded to an interposer (see, *e.g.,* FIG. 4). As noted above, this attachment or bonding may be performed using plasma wafer bonding, adhesives, anodic bonding, eutectic bonding, *etc.,* as appropriate for the materials and processing node technologies. A device so constructed and bonded may be released from the growth substrate (such as illustrated and described with reference to the inversion techniques), for example, subsequent to the bonding of the interposer, which may be operative to reconfigure the peripheral array connections of the device as set forth above. This peripheral connection structure may then be addressed using interconnect with larger bondpads and/or a greater pitch than might otherwise be possible in a directly addressed structure. Following laser lift-off or mechanical separation of the LED layer, a surface layer of gallium-rich semiconductor material and/or gallium metal may be left behind. This layer may have a significantly higher lateral conductivity than optimal for interconnect. Removal of this residue after laser lift-off (*e.g.,* using a chlorine etch or wet etching process) may reduce the conductivity of this layer and allow for superior spatial control of the interconnect in some circumstances.

For implementing a color conversion structure, a phosphor (or phosphor-based) conversion layer may be deposited on the LED or micro-LED structure after release from the growth substrate. This conversion layer can be a single color (*e.g.,* a broad spectrum white), or multiple spatially patterned colors integrating two or more colors for emission. Phosphors that can be used include inorganic phosphors, quantum dots, organic materials, defect emitters in wide bandgap structures, and nanophosphors. Integration of the wavelength conversion elements on a thinned LED or micro-LED structure reduces the waveguiding that may otherwise occur in the substrate slab. This approach is illustrated in and described above with reference to FIG. 5.

In accordance with one aspect, such color conversion layers may also be integrated with a filter before or after (or both before and after) the color conversion layer to improve spectral quality of the emitted light, such as by reducing a bandwidth of spectral output of quantum dots, removing excitation light from the emitted spectrum, or both. This is described above with reference to FIG. 6. Such a filter or filtering technique may be used, for example, to create multiple colors from a blanket white or yellow phosphor, to remove or minimize excitation light from a composite light source, to improve spectral characteristics of a phosphor, or to create a combination of these and other effects. A black matrix may also be integrated in such a structure to reduce or minimize lateral waveguiding and to improve isolation of discrete pixels. As described above with reference to FIG. 7, such a color conversion structure may be fabricated independently, such as on a separate element or color conversion plate or module, that may be bonded to the micro-LED structure.

In accordance with some disclosed implementations, a thinned LED layer, or even a residual growth layer, may be patterned to include optical extraction elements or wavelength control structures (see, *e.g.,* FIGS. 8 and 9). Such elements may include prisms, gratings, photonic crystals, lenses (*e.g.,* shallow etched Fresnel lenses), phosphors, quantum dots, scattering elements, and filters. These elements may be used to improve outcoupling of light from waveguiding effects of the substrate or semiconductor layers (improving output efficiency), to improve an output cone angle (*e.g.,* for better optical collection), to direct the light in specific directions (*e.g.,* for patterned directional emitters, such as in light field displays), to improve switching speed (*e.g.,* through creation of a strong cavity for emission), or to effectively direct the light to color conversion elements or enhance their efficacy (*e.g.,* through amplification of a cavity in which the phosphors or filtering materials are present). The structured optical extraction elements may also be enhanced with dielectric filters, dielectric or metallic mirrors, or plasmonic optical elements to enhance or further to facilitate these functionalities.

Laser lift-off techniques typically remove all of the growth substrate, but as noted above with reference to the FIG. 9 implementation in which polishing is used as an alternative for substrate removal, it is also possible to terminate the polish before reaching the semiconductor layer, thereby leaving some residual growth substrate (*e.g.,* sapphire). This remaining material may be used as the medium in which such optical extraction or enhancement elements may be placed. Such optical extraction elements may include the optical structures discussed above (such as lenses, prisms, *etc*.)*,* wells for deposition of quantum dots, surfaces for deposition or volumes for placement of color filters, *etc.* as illustrated in FIG. 9. The LED structure may then be contacted via etching through the remaining sapphire, using a heavily doped ground plane, or contacted through vias cut on the top side. After etching, air or vacuum may serve as an index contrast material, or another material or set of materials (*e.g.,* a sol gel, polymer, aerogel, nanoparticle composite, *etc*.) may be added to create index contrast or transition between refractive indices. It is also possible to consider the growth of a layer on the released substrate (using epitaxy or other means) to form an adequate layer for incorporation of the optical elements.

In accordance with another feature, a disclosed alternative implementation employs a relatively thicker layer of semiconductor material (such as a thick underlying GaN layer, for instance); such a relatively thicker layer may generally provide extra material for patterning of required or desired optical extraction elements while allowing contacting through the stack. This approach, illustrated in FIG. 10, may enable or facilitate the use of laser lift-off while permitting a significant quantity of optically transparent material for the fabrication of optical structures such as optical extraction elements.

In cooperation or combination with any of the foregoing processing approaches, electrical connections to the electrodes may be made using conducting adhesives, anisotropic conducting elements (such as heat seal conductors or elastomeric connectors), or other bonding structures or methodologies generally known in the art. For example, electrical connection may be performed using bump bonding to a carrier or interposer that accommodates the driver chips. Such a carrier can be structured to accommodate contacts on either side (i.e., top or bottom) or on both sides of the LED wafer. Optical access may also be configured for top, bottom, or dual light extraction through the selection (and selective positioning) of reflective electrodes and optical access in the carrier as set forth above with particular reference to FIG. 11. Heatsinking to the LED layer may be attached to the non-emitting side (i.e., on top or bottom, as the case may be), and a reflective electrode may allow for or otherwise control a direction of extraction of the light.

Several features and aspects of a system and method have been illustrated and described in detail with reference to particular embodiments by way of example only, and not by way of limitation. The invention is defined by the appended claims.

## Claims

1. A method of fabricating display structures, the method comprising:
receiving a wafer which comprises a growth substrate (120) and an epitaxial semiconductor layer (110) grown on a first face of the growth substrate, patterning the epitaxial semiconductor layer of the wafer from a front face of the epitaxial semiconductor layer to form a common electrode contact (130) of a set of micro-light emitting diodes (micro-LEDs),
bonding the common electrode contact to a carrier substrate (140),
releasing the growth substrate from the epitaxial semiconductor layer to expose a back face of the epitaxial semiconductor layer, the back face opposed from the front face across a thickness of the epitaxial semiconductor layer,
providing individually addressable contacts (150) on the back face of the epitaxial semiconductor layer, such that the common electrode contact, the epitaxial semiconductor layer and the individually addressable contacts form the set of micro-light emitting diodes, and
electrically coupling a set of drive circuitry (170) o the individually addressable contacts to control the micro-LEDs.

2. The method of claim 1, further comprising:
patterning the epitaxial semiconductor layer to form a respective discrete semiconductor element for each of the micro-LEDs.

3. The method of claim 1 wherein bonding the common electrode contact to the carrier substrate includes bonding the common electrode contact to a transparent or translucent carrier substrate, where light emission from the micro-LEDs will pass through the transparent or translucent carrier substrate.

4. The method of claim 1 wherein electrically coupling the set of drive circuitry to the individually addressable contacts to control the micro-LEDs includes electrically coupling a set of complementary metal oxide semiconductor (CMOS) circuits to the individually addressable contacts to control the micro-LEDs.

5. The method of claim 1, further comprising:
depositing an insulating layer (280) over individually addressable contacts, and
forming vias in the insulating layer to provide a set of electrical connections to the individually addressable contacts through the insulating layer.

6. The method of claim 5 wherein electrically coupling a set of drive circuitry to the individually addressable contacts to control the micro-LEDs includes electrically coupling a set of thin film transistor (TFT) circuits (290) to the individually addressable contacts to control the micro-LEDs.

7. The method of claim 1 wherein bonding the common electrode contact to the carrier substrate includes bonding the common electrode contact to a translucent carrier substrate that is wavelength selective.

8. The method of claim 1 wherein releasing the growth substrate includes performing a laser lift-off.

9. The method of claim 1 wherein releasing the growth substrate includes polishing the growth substrate and removing residue from the polishing of the growth substrate.

10. The method of claim 1, further comprising:
adding one or more optical features to the carrier substrate.

## Patentansprüche

1. Verfahren zum Herstellen von Anzeigestrukturen, das Verfahren umfassend:
Erhalten eines Wafers, der ein Wachstumssubstrat (120) und eine epitaktische Halbleiterschicht (110) umfasst, die auf eine erste Fläche des Wachstumssubstrats aufgewachsen ist,
Strukturieren der epitaktischen Halbleiterschicht des Wafers von einer Vorderseite der epitaktischen Halbleiterschicht aus, um einen gemeinsamen Elektrodenkontakt (130) eines Satzes von lichtemittierenden Mikro-Dioden (Mikro-LEDs) zu bilden,
Bonden des gemeinsamen Elektrodenkontakts an ein Trägersubstrat (140),
Lösen des Wachstumssubstrats von der epitaktischen Halbleiterschicht, um eine Rückseite der epitaktischen Halbleiterschicht freizulegen, wobei die Rückseite über eine Dicke der epitaktischen Halbleiterschicht der Vorderseite gegenüberliegt,
Bereitstellen von einzeln adressierbaren Kontakten (150) auf der Rückseite der epitaktischen Halbleiterschicht, so dass der gemeinsame Elektrodenkontakt, die epitaktische Halbleiterschicht und die einzeln adressierbaren Kontakte den Satz von lichtemittierenden Mikro-Dioden bilden, und
elektrisches Koppeln eines Satzes von Treiberschaltungen (170) mit den einzeln adressierbaren Kontakten zur Steuerung der Mikro-LEDs.

2. Verfahren nach Anspruch 1, ferner umfassend
Strukturieren der epitaktischen Halbleiterschicht, um ein jeweiliges diskretes Halbleiterelement für jede der Mikro-LEDs zu bilden.

3. Verfahren nach Anspruch 1, bei dem das Bonden des gemeinsamen Elektrodenkontakts an das Trägersubstrat das Bonden des gemeinsamen Elektrodenkontakts an ein transparentes oder transluzentes Trägersubstrat einschließt, wobei die Lichtemission von den Mikro-LEDs durch das transparente oder transluzente Trägersubstrat hindurchgeht.

4. Verfahren nach Anspruch 1, bei dem das elektrische Koppeln des Satzes von Treiberschaltungen mit den einzeln adressierbaren Kontakten zur Steuerung der Mikro-LEDs das elektrische Koppeln eines Satzes von komplementären Metalloxid-Halbleiterschaltungen (CMOS) mit den einzeln adressierbaren Kontakten zur Steuerung der Mikro-LEDs umfasst.

5. Verfahren nach Anspruch 1, ferner umfassend:
Ablagern einer Isolierschicht (280) über einzeln adressierbaren Kontakten, und
Ausbilden von Durchkontaktierungen in der Isolierschicht, um einen Satz von elektrischen Verbindungen zu den einzeln adressierbaren Kontakten durch die Isolierschicht bereitzustellen.

6. Verfahren nach Anspruch 5, bei dem das elektrische Koppeln eines Satzes von Treiberschaltungen mit den einzeln adressierbaren Kontakten zur Steuerung der Mikro-LEDs das elektrische Koppeln eines Satzes von Dünnfilmtransistor-(TFT)-Schaltungen (290) mit den einzeln adressierbaren Kontakten zur Steuerung der Mikro-LEDs umfasst.

7. Verfahren nach Anspruch 1, bei dem das Bonden des gemeinsamen Elektrodenkontakts an das Trägersubstrat das Bonden des gemeinsamen Elektrodenkontakts an ein transluzentes Trägersubstrat einschließt, das wellenlängenselektiv ist.

8. Verfahren nach Anspruch 1, bei dem das Lösen des Wachstumssubstrats das Durchführen eines Laser-Abhebens umfasst.

9. Verfahren nach Anspruch 1, wobei das Lösen des Wachstumssubstrats das Polieren des Wachstumssubstrats und das Entfernen von Rückständen vom Polieren des Wachstumssubstrats umfasst.

10. Verfahren nach Anspruch 1, ferner umfassend:
Hinzufügen einer oder mehrerer optischer Eigenschaften zu dem Trägersubstrat.

## Revendications

1. Procédé de fabrication de structures d'affichage, le procédé comprenant:
recevoir une plaquette qui comprend un substrat de croissance (120) et une couche semi-conductrice épitaxiale (110) développée sur une première face du substrat de croissance,
former des motifs sur la couche semi-conductrice épitaxiale de la plaquette à partir d'une face avant de la couche semi-conductrice épitaxiale pour former un contact d'électrode commun (130) d'un ensemble de micro-diodes électroluminescentes (micro-LED),
lier le contact d'électrode commun à un substrat porteur (140),
libérer le substrat de croissance de la couche semi-conductrice épitaxiale pour exposer une face arrière de la couche semi-conductrice épitaxiale, la face arrière étant opposée à la face avant sur une épaisseur de la couche semi-conductrice épitaxiale,
fournir des contacts adressables individuellement (150) sur la face arrière de la couche semi-conductrice épitaxiale de telle sorte que le contact d'électrode commun, la couche semi-conductrice épitaxiale et les contacts adressables individuellement forment ledit ensemble de micro-diodes électroluminescentes, et
coupler électriquement un ensemble de circuits d'attaque (170) aux contacts adressables individuellement pour commander les micro-LED.

2. Procédé selon la revendication 1, comprenant en outre:
former des motifs sur la couche semi-conductrice épitaxiale pour former un élément semi-conducteur discret respectif pour chacune des micro-LED.

3. Procédé selon la revendication 1, dans lequel la liaison du contact d'électrode commun au substrat porteur comprend la liaison du contact d'électrode commun à un substrat porteur transparent ou translucide, dans lequel l'émission de lumière provenant des micro-LED passera à travers le substrat porteur transparent ou translucide.

4. Procédé selon la revendication 1, dans lequel le couplage électrique de l'ensemble de circuits d'attaque aux contacts adressables individuellement pour commander les micro-LED comprend le couplage électrique d'un ensemble de circuits semi-conducteurs à oxyde de métal complémentaire (CMOS) aux contacts adressables individuellement pour commander les micro-LED.

5. Procédé selon la revendication 1, comprenant en outre:
déposer une couche isolante (280) sur des contacts adressables individuellement, et
former des vias dans la couche isolante pour fournir un ensemble de connexions électriques aux contacts adressables individuellement à travers la couche isolante.

6. Procédé selon la revendication 5, dans lequel le couplage électrique d'un ensemble de circuits d'attaque aux contacts adressables individuellement pour commander les micro-LED comprend le couplage électrique d'un ensemble de circuits à transistor à couches minces (TFT) (290) aux contacts adressables individuellement pour commander les micro-LED.

7. Procédé selon la revendication 1, dans lequel la liaison du contact d'électrode commun au substrat porteur comprend la liaison du contact d'électrode commun à un substrat porteur translucide qui est sélectif en longueur d'onde.

8. Procédé selon la revendication 1, dans lequel la libération du substrat de croissance comprend la réalisation d'un décollage laser.

9. Procédé selon la revendication 1, dans lequel la libération du substrat de croissance comprend le polissage du substrat de croissance et l'élimination de résidus du polissage du substrat de croissance.

10. Procédé selon la revendication 1, comprenant en outre:
ajouter une ou plusieurs caractéristiques optiques au substrat porteur.
